# EUROPEAN PATENT APPLICATION

(11) **EP 4 703 185 A1**
(43) Date of publication of application: **04.03.2026**
(21) Application number: 24196464.2
(22) Date of filing: 26.08.2024
(51) Int. Cl.: B60L 53/18, B60L 53/302

(54) **COOLED CHARGING CONDUCTOR ASSEMBLY WITH EXTENDED INTERNAL HEAT TRANSFER SURFACES**

(71) Applicant: Aptiv Technologies AG, 8200 Schaffhausen (CH)
(72) Inventor: WOLNY, Jan, 8200 Schaffhausen (CH); PIESZKA, Monika, 8200 Schaffhausen (CH); KOZAK, Pawel, 8200 Schaffhausen (CH)
(74) Representative: Bardehle Pagenberg Partnerschaft mbB Patentanwälte Rechtsanwälte

(57) **Abstract**

The present invention relates to a high voltage power conductor assembly (1) comprising a tubular electrical conductor (2) and an outer insulation (3) surrounding the tubular electrical conductor (2). The tubular electrical conductor (2) has an inner surface (21) with protrusions (22) for increasing heat transfer. The inner surface (21) defines a channel (24) configured for receiving a coolant (4) from a cooling system designed to evacuate heat from the electrical conductor (2) to the coolant (4) when in use.

## Description

### 1. Field of the invention

The present application relates in general to high voltage power conductor assemblies, and more particularly, to a power conductor assembly configured for coupling to a coolant system and which can incorporate such an integrated coolant system.

### 2. Background

Charging of high voltage batteries, for example in the field of automotive technology, requires the use of heavy gauge high voltage (HV) power conductor assemblies that can handle the level of current required to ensure fast charging. The HV power conductor assemblies used in battery charging applications and/or power distribution applications are often provided with a cooling system to ensure that the heat generated at the electrical conductor due to the high current flow is dissipated away, thereby increasing the efficiency and safety of the charging operation.

In one existing approach of the prior art, passive cooling solutions may be applied to reduce the temperature dissipated by a HV power connector assembly. However, passive cooling solutions are limited due to manufacturing and weight constraints. For example, changing the dimensions of the components, e.g. increase the electrical conductor gauges, to reduce temperature would increase the weight and cost of the power cable assembly, while reducing its flexibility.

Examples of known cable cooling systems are e.g., described in WO201860151. Here, a charging system for charging an electric vehicle is disclosed, comprising a plug-in connector part for plug-in connection to a mating connector part of the electric vehicle. The system further comprises a charging cable on which the plug-in connector part is arranged and which comprises at least one load line for transmitting an electrical current and at least one fluid line for guiding a gaseous fluid for cooling the charging cable and the plug-in connector part arranged on the charging cable. A conveyor device is fluidically connected to the at least one fluid line, for conveying a gaseous fluid into the at least one fluid line A charging system is thereby provided, which allows cooling using a gaseous fluid.

There is still room for improvement of power connector assemblies with a coolant system. It is in particular desirable to provide a high voltage connector assembly that enables faster and safer charging.

### 3. Summary of the invention

The above-mentioned object is at least partially realized by a high voltage power conductor assembly according to claim 1 or by a method of cooling a high voltage power conductor assembly according to claim 14. Preferred embodiments are the subject of the dependent claims, and the skilled person will find clues to other suitable aspects of the present invention in the overall disclosure of the present application.

An aspect of the invention relates to a high voltage power conductor assembly comprising a tubular electrical conductor and an outer insulation surrounding the tubular electrical conductor. The tubular electric conductor can have different cross-sections, depending on the circumstances, as long as it is tubular, i.e. the conductor has a hollow interior space. Within the interior space, the tubular electrical conductor has an inner surface with protrusions intended to increase heat transfer. With protrusions the contact surface with the content of the interior space is increased, which in turn increases the heat transfer from the conductor to the content of the channel. The inner surface defines a channel which can receive a coolant from a cooling system designed to evacuate heat from the conductor to the coolant when in use.

The protrusions can be of different nature such as in form of a coarse inner surface, a patterned surface with protruding dots, waves, etc. In a preferred embodiment however, at least part of the protrusions are fins, preferably linear fins in the extension direction of the tubular electrical conductor. Fins can easily and economically be produced by drawing the tubular electrical conductor. When the fins extend in the main direction of the tubular electrical conductor, the fins also follow the heat gradient within the electrical conductor, which additionally improves the heat transfer performance.

In cross-section, the fins can have a triangular shape. The fins could in particular also have a circular triangular cross-section or a negatively curved triangular cross section. Rectangular, zig-zag shapes or wave-like shapes are also possible. All of these arrangements increase the heat-exchanging surface while keeping enough solid material to ensure a good heat transfer performance.

To ensure a good heat transfer while keeping the extra material required low at least 10 fins should be disposed on the inner surface of the tubular conductor. The heat transfer performance can be further enhanced having between 30 and 200 fins, and even more between 60 and 200 fins. Generally, the number of fins depends on the diameter of the conductor, whereby the performance of the conductor assembly does not improve beyond a given threshold of fin which depends on the diameter.

Similarly, also the height [h] with which the fins protrude from the inner surface of the electrical conductor has an influence on the heat exchanging surface. A significant increase in the heat exchanging surface is obtained with a height of at least 0,2 mm. The heat transfer performance can be further enhanced having a height of at least 0,4 mm, and even more at a height of at least 0,6 mm. However, increasing the height of fin doesn't improve heat transfer indefinitely. At some point the fin's tip reaches the temperature of the fluid and increasing the height will not improve the heat transfer anymore since there is no temperature difference between the fin and the fluid. As such, the height of the fin is a parameter that needs to be optimized depending on the application, taking into account fluid type, temperature, current carried by the conductor, conductor internal diameter etc.

A good relation dᵢ/h between the inner diameter [dᵢ] of the tubular conductor and the height [h] with which the linear fins protrude from the inner surface of the electrical conductor has proven to be between 8 and 100. Within these boundaries the conducting properties match the cooling properties. This means that the coolant amount does not exceed what is needed for a good power conduction. The power conduction performance can be further enhanced having a relation dᵢ/h between 10 and 75, and even more having a relation dᵢ/h between 10 and 50.

As an example: a relation d;/h of 40 means that the protruding height of a fin is 40 times larger than the inner diameter. Thus, with a fin height of e.g., 0,5 mm, the inner diameter would be 20 mm.

The high voltage power conductor assembly conveniently includes a coolant system and a coolant within the channel. The coolant system is configured to allow the coolant to circulate within the channel to evacuate heat produced by the conductor in use. The coolant system may for example be provided with a heat exchanger to effectively transfer the heat taken up by the coolant from the conductor assembly to the environment.

When the inner surface of the tubular electrical conductor is insulated, coolants comprising water, gycol and/or similar materials or combinations thereof can be used. These have the advantage of being unexpensive. In case the tubular electrical conductor is not insulated, dielectric coolants such as for example hydrofluoethers (HFE) have proven to evacuate heat efficiently. The type of coolant is conveniently chosen taking into account the system architecture, such as dimensions, maximum voltage power etc.

When the coolant circulates at a flow rate of at least 0.5 l/min, more preferably at least 1.5 l/min, even more preferably at least 3 l/min, a good heat evacuation is obtained. Exact flow rate value will of course depend on the application and the diameter of the conductor.

The coolant system can further include an inlet on a first end of the channel and an outlet on a second end of the channel, wherein the inlet and the outlet are configured to allow a steady flow of coolant.

Additionally, the inlet and/or the outlet may comprise means to selectively regulate the flow rate of the coolant. The flow rate can then be adapted to the current flow in the tubular electrical conductor such that the heat exchange is optimized for each charging configuration.

The conductor can be made of known conductive material such as high conductivity copper alloys, copper or aluminum. The wall thickness of conductor can thereby be chosen between 0.5 mm and 20 mm, preferably between 0.7 mm and 10 mm, more preferably between 0.9 mm and 5 mm to ensure sufficient power conduction properties and ultimately a sufficient charging speed.

The protrusions are conveniently integrally formed with the conductor when the conductor itself is produced. This is a cost-effective way of adding protrusions as no extra production step is needed. E.g., when the tubular electrical conductor is produced, for example as formed and welded steel tubes or as seamless, hot-rolled or drawn tubes, the inner protrusions are simultaneously produced, and no extra production step is needed.

According to another aspect of the invention, a method of cooling a high voltage power conductor assembly while charging a battery, in particular while charging an electric vehicle, is disclosed. The method comprises the steps of providing a high voltage power conductor assembly of the invention and connecting it to a battery and an electricity source such that the connected battery can be charged. To evacuate heat produced in the tubular electrical conductor, a coolant system is connected in a way that a dielectric coolant can circulate within a channel of the tubular electrical conductor.

Thereby, the coolant system can be connected the tubular electrical conductor through an inlet and an outlet located at the ends of the channel to a coolant supply. For best heat evacuation performance, it is preferable to include means to regulate the flow rate of the coolant to adapt it to the current flow in the electrical conductor.

### 4. Short description of the drawings

In the following, preferred embodiments of the disclosure are discussed by reference to the accompanying figures, wherein:
Fig. 1 shows the cross-section of an embodiment of the high voltage power conductor assembly;
Fig. 2 shows a three-dimensional view of the embodiment of Fig. 1.

### 5. Detailed description of preferred embodiments

In the following, preferred embodiments of the present disclosure are described in detail with respect to the figures.

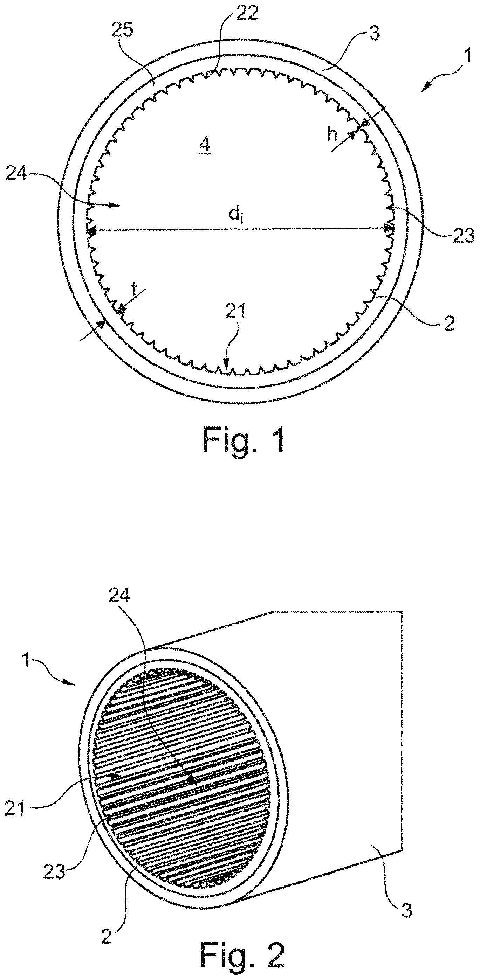

Fig. 1 shows a cross-sectional view of an embodiment of a high voltage power conductor assembly 1. A tubular electrical conductor 2 is surrounded by an outer insulation 3 and comprises a channel 24 therein. The channel 24 is defined by an inner surface 21 of the tubular conductor 2. The tubular conductor 2 is made from an electroconductive material to conduct electricity, in particular for high voltage applications, like charging the batteries of an electric or hybrid vehicle. The channel is supposed to be filled with a dielectric coolant 4 which coolant is associated with a coolant system (not shown) designed to evacuate heat from the electrical conductor. The dielectric coolant preferably flows through the channel 24 and is circulated through a heat exchanger to dissipate the heat taken up from the electrical conductor 2.

The tubular electrical conductor 2 is preferably provided in form of a rigid pipe element, but may also have some flexibility. The outer insulation 3 is made from a non-conductive material, like e.g., materials commonly used for the insulations of electrical cables or similar. It may also serve for protection against mechanical impacts.

The inner surface 21 of the electrical conductor 2 is provided with protrusions 22 to increase the heat transfer surface and thus enhance the heat transfer from the electrical conductor 2 to the dielectric coolant flowing through the channel 24. In the shown embodiment the protrusions are realized in form of 64 elongated fins 23. However, this is only exemplary and other numbers of fins are likewise possible. The number of fins should be preferably at least 10, more preferably between 30 and 200, and even more preferably between 60 and 200.

The fins 23 have a triangular cross-section as seen in a plane perpendicular to the extension direction of the conductor 2 (which is the plane shown in Fig. 1). The fins protrude with their tips pointing inwards towards the interior of the channel 24.

Additionally, in Fig. 1 the dimensions [h] of the height of the fins (23), [dᵢ] of the inner diameter of the tubular electrical conductor 2 and [t] of the thickness of the conductor wall 25 are indicated. The height [h] with which the fins 23 protrude from the inner surface 21 of the electrical conductor 2 is in the shown embodiment about 0,8 mm. Generally, the height is preferably at least 0,2 mm, more preferably at least 0,4 mm, and even more preferably at least 0,6 mm.

The relation dᵢ/h between the inner diameter [dᵢ] of the tubular electrical conductor 2 and the height [h] with which the linear fins 23 protrude from the inner surface 21 of the tubular electrical conductor 2 in the shown embodiment is approximately 40. Generally, the ratio is preferably between 8 and 100, more preferably between 10 and 75, and even more preferably between 10 and 50.

Fig. 2 shows the same embodiment of the high voltage power conductor assembly 1 as shown in Fig. 1 in a three-dimensional view. In this figure it is visible that in the shown embodiment, the fins extend linearly in the extension direction of the conductor, i.e. they run parallel to the extension direction of the tubular conductor 2. However, while this is a preferred arrangement due to the advantages associated with the manufacturing thereof, also other forms and orientations of fins or other protrusions are feasible.

### List of reference signs

- 1: high voltage power conductor assembly
- 2: tubular electrical conductor
- 21: inner surface
- 22: protrusions
- 23: fins
- 24: channel
- 25: conductor wall
- 3: outer insulation
- 4: coolant

## Claims

1. High voltage power conductor assembly (1) comprising:
a tubular electrical conductor (2); and
an outer insulation (3) surrounding the tubular electrical conductor (2);
the tubular electrical conductor (2) having an inner surface (21) with protrusions (22) for increasing heat transfer,
the inner surface (21) defining a channel (24) configured for receiving a coolant (4) from a cooling system designed to evacuate heat from the electrical conductor (2) to the coolant (4) when in use.

2. High voltage power conductor assembly (1) according to claim 1, wherein at least part of the protrusions are fins (23), preferably linear fins (23) in the extension direction of the tubular electrical conductor (2).

3. High voltage power conductor assembly (1) according to the previous claim, wherein the fins (23) have a triangular cross-section.

4. High voltage power conductor assembly (1) according to claim 2 or 3, wherein at least 10 fins (23) are disposed on the inner surface, more preferably between 30 and 200 fins (23), even more preferably between 60 and 200 fins (23).

5. High voltage power conductor assembly (1) according to any claim 2 to 4, wherein the height [h] with which the fins (23) protrude from the inner surface (21) of the electrical conductor (2) is at least 0,2 mm, more preferably at least 0,4 mm, even more preferably at least 0,6 mm.

6. High voltage power conductor assembly (1) according to any claim 2 to 5, wherein the relation dᵢ/h between the inner diameter [dᵢ] of the tubular electrical conductor (2) and the height [h] with which the linear fins (23) protrude from the inner surface (21) of the tubular electrical conductor (2) is between 8 and 100, preferably between 10 and 75, more preferably between 10 and 50.

7. High voltage power conductor assembly (1) according to any previous claim, including a coolant system and a coolant (4) within the channel (24), the coolant system being configured to allow the coolant (4) to circulate within the channel (24) to evacuate heat produced by the tubular electrical conductor (2) in use.

8. High voltage power conductor assembly (1) according to the previous claim, wherein the inner surface (21) of the tubular electrical conductor (2) is insulated and the coolant (4) comprises water, glycol and/or similar or combinations thereof, or wherein the coolant (4) is a dielectric coolant, such as hydrofluorethers (HFE) or similar.

9. High voltage power conductor assembly (1) according to claim 7 or 8, wherein the coolant (4) is configured to circulate at a flow rate of at least 0.5 l/min, more preferably at least 1.5 l/min, even more preferably at least 3 l/min.

10. High voltage power conductor assembly (1) according to any of claims 7 to 9, wherein the coolant system further includes an inlet on a first end of the channel (24) and an outlet on a second end of the channel (24), the inlet and the outlet being configured to allow a steady flow of coolant (4).

11. High voltage power conductor assembly (1) according to the previous claim, wherein the inlet and/or the outlet comprise means to selectively regulate the flow speed of the coolant (4).

12. High voltage power conductor assembly (1) according to any previous claim, wherein the wall thickness [t] of tubular electrical conductor (2) is between 0.5 mm and 20 mm, preferably between 0.7 mm and 10 mm, more preferably between 0.9 mm and 5 mm.

13. High voltage power conductor assembly (1) according to any previous claim, wherein the protrusions (22) are integrally formed with the tubular electrical conductor (2).

14. Method of cooling a high voltage power conductor assembly (1) according to any of claims 1 to 13 while charging a battery, in particular while charging an electric vehicle, the method comprising the steps of
providing a high voltage power conductor assembly (1) according to any of claims 1 to 13;
connecting the tubular electrical conductor (2) to a battery and an electricity source such that the connected battery can be charged;
connecting a coolant system such that a coolant (4) can circulate within the channel (24) and evacuate heat produced by the tubular electrical conductor (2).

15. Method according to claim 14, wherein connecting the coolant system comprises connecting an inlet and an outlet of the channel (24) to a coolant supply, and wherein the method preferably further comprises the step of regulating the flow speed of the coolant (4) to adapt it to the current flow in the electrical conductor.
